# FASCICULE DE BREVET EUROPEEN

(11) **EP 3 161 181 B1**
(45) Date de publication et mention de la délivrance du brevet: **19.08.2020**
(21) Numéro de dépôt: 15747756.3
(22) Date de dépôt: 25.06.2015
(51) Int. Cl.: C23C 16/04, C23C 16/06, C23C 16/44, B01J 23/38, B01J 37/02

(54) **DISPOSITIF DE DEPOT CHIMIQUE EN PHASE VAPEUR A RENDEMENT DE DEPOT AMELIORE**
CVD-VORRICHTUNG MIT VERBESSERTER ABSCHEIDUNGSEFFIZIENZ
CHEMICAL VAPOUR DEPOSITION DEVICE WITH IMPROVED DEPOSITION EFFICIENCY

(30) Priorité: 25.06.2014 FR 1455907
(43) Date de publication de la demande: 03.05.2017
(73) Titulaire: Commissariat à l'Énergie Atomique et aux Énergies Alternatives, 75015 Paris (FR); Renault S.A.S., 92100 Boulogne-Billancourt (FR)
(72) Inventeur: DONET, Sébastien, 38112 Meaudre (FR); JOUVE, Michel, 38470 Vinay (FR)
(74) Mandataire: Brevalex
(86) Numéro de dépôt international: PCT/EP2015/064347
(87) Numéro de publication internationale: WO 2015/197748

(56) Documents cités:
- EP-A2- 2 251 452
- DE-A1- 19 646 094
- FR-A1- 2 930 562
- JP-A- H08 206 517
- US-A- 3 484 276
- US-A- 5 569 455

## Description

### DOMAINE TECHNIQUE ET ÉTAT DE LA TECHNIQUE ANTÉRIEURE

La présente invention se rapporte à un dispositif de dépôt chimique en phase vapeur, notamment à un dispositif de dépôt chimique en phase vapeur de métaux offrant un rendement de dépôt amélioré.

Dans le domaine automobile, on utilise des catalyseurs métalliques, par exemple pour convertir les oxydes d'azote NOx. Ces catalyseurs sont déposés sur une structure par exemple en nid d'abeille qui est ensuite montée dans la ligne d'échappement.

Les métaux mis en œuvre sont par exemple le platine, le palladium et le rhodium.

Habituellement, l'imprégnation par voie liquide est le procédé principal pour préparer les structures recouvertes de catalyseurs métalliques. Ce procédé requiert une imprégnation de 24 heures, le support imprégné de catalyseur est ensuite récupéré, séché et calciné à 550°C pendant quelques heures.

Un autre procédé permettant le dépôt d'un métal sur un substrat est le procédé dit de dépôt chimique en phase vapeur et plus particulièrement le procédé dit de dépôt chimique en phase vapeur d'organométalliques (« *OMCVD* » ou « *Organometallic Chemical Vapour Deposition* » en anglais). Ce procédé présente de nombreux avantages par rapport à des procédés tels que l'imprégnation ou à des procédés de dépôt physique en phase vapeur. En effet, le procédé d'OMCVD permet de recouvrir les pièces de géométries macroscopiquement complexes telles que les supports catalytiques par exemple les mousses, les nids d'abeille en céramique, et zéolithes, sans qu'il soit nécessaire de travailler dans des domaines de vide poussé. On peut ainsi opérer à une pression allant de 100 Pa à la pression atmosphérique, par exemple de 100 Pa à 500 Pa, ce qui en fait un procédé facilement industrialisable lorsqu'on le compare au procédé de dépôt physique en phase vapeur par exemple.

Un procédé de MOCVD est par exemple décrit dans le document WO2006070130. Ce procédé permet de réaliser des dépôts conformes de couches d'oxydes tels que TiO₂, ZrO₂, CeO₂, STO et de nanoparticules métalliques de platine, Palladium, Rhodium, argent... et leurs alliages

Le procédé de dépôt par MOCVD est mis en œuvre au moyen d'un dispositif comportant une enceinte dans laquelle est disposée la pièce sur laquelle on souhaite faire le dépôt, un injecteur et un évaporateur des précurseurs organométalliques et du solvant en amont de l'enceinte et un circuit de récupération des produits sortant de l'enceinte. La pièce est chauffée par exemple par rayonnement. Un groupe de pompage est disposé dans ce circuit. Des pièges à chaud et des pièges à azote liquide disposés dans le circuit piègent les précurseurs et les solvants, respectivement, avant qu'ils n'atteignent le groupe de pompage, de tels produits pouvant provoquer la corrosion du groupe et son usure prématurée. En outre, ces produits présentent une certaine toxicité et il est préférable d'éviter de les rejeter. Au niveau du groupe de pompage sont prévus également un piège à haute température et un brûleur, également désigné scrubber, permet de neutraliser une partie du mélange gazeux sortant de l'enceinte.

Le rendement de dépôt chimique en phase vapeur est compris entre 15% et 30%, les métaux restant se retrouvent en partie piégés par les pièges et en partie dans la tuyauterie et dans les vannes du circuit en aval du réacteur.

Ces métaux non déposés ne sont pas récupérés car le coût et la complexité pour récupérer ces métaux seraient trop importants. En outre, les métaux récupérés dans les pièges ne sont pas dans le même état que lors de leur injection dans le réacteur. Un recyclage serait donc nécessaire ce qui impliquerait une dévaluation des métaux récupérés.

En tenant compte du fait que les métaux déposés notamment pour réaliser des catalyseurs pour traiter les gaz d'échappement automobile sont des métaux précieux, il résulte du faible rendement de dépôt et de la non-récupération des métaux non déposés un prix de réalisation des pièces par cette technique très élevé.

Le document DE19646094 présente un système d'infiltration de l'intérieur d'une pièce où les gaz précurseurs sont réinjectés dans la chambre de traitement.

### EXPOSÉ DE L'INVENTION

C'est par conséquent le but de la présente invention d'offrir un dispositif de dépôt chimique en phase vapeur dans lequel la quantité de métaux perdus est sensiblement réduite.

Le but énoncé ci-dessus est atteint par un dispositif de dépôt chimique en phase vapeur dans lequel le ou les précurseurs du métal ou des métaux à déposer et le gaz réactif sous forme gazeuse sont injectés à l'intérieur de la pièce à traiter

Dans l'état de la technique, la pièce est disposée dans un réacteur et le mélange sous forme gazeuse est injecté dans tout le volume du réacteur. Le volume périphérique entre la paroi extérieure de la pièce et la paroi du réacteur est rempli du mélange gazeux, une partie du mélange contenu dans le volume périphérique sert à recouvrir la face extérieure de la paroi extérieure de la pièce, l'autre partie ne sert pas et est évacuée directement. Les inventeurs ont constaté que les métaux déposés sur la face extérieure de la paroi extérieure de la pièce jouaient un rôle limité, par exemple dans le cas où la pièce ainsi recouverte sert au traitement des gaz d'échappement, le gaz circulant à l'intérieur de la pièce.

Grâce à l'invention, en ne faisant circuler le mélange gazeux qu'à l'intérieur de la pièce, le volume de mélange gazeux requis lors de chaque dépôt est réduit sensiblement tout en réalisant le dépôt d'une couche de même épaisseur sur les surfaces intérieures de la pièce. Ainsi le rendement de dépôt peut être sensiblement augmenté tout en offrant des pièces recouvertes offrant la même efficacité ou sensiblement la même efficacité que les pièces dont la surface extérieure est recouverte par un dispositif de l'état de la technique.

L'injection à l'intérieur de la pièce est par exemple obtenue au moyen d'un connecteur reliant l'injecteur et à l'intérieur de la pièce. Ce connecteur est appelé "cône de forçage". La deuxième extrémité de la pièce est connectée à un circuit de récupération du mélange gazeux contenant les espèces n'ayant pas réagies.

Il peut être prévu de ne plus utiliser de réacteur, la pièce confinant le mélange gazeux et le guidant vers la zone d'évacuation.

De manière avantageuse, on réalise un recyclage d'une partie du mélange gazeux sortant de la pièce en faisant recirculer une partie du mélange gazeux dans la pièce à traiter. De préférence le mélange gazeux est enrichi en précurseurs avant d'être réintroduit dans la pièce.

De manière également très avantageuse, un piège à haute température est disposé dans le circuit de pompage et de récupération en aval de la pièce afin de récupérer les précurseurs au plus tôt et éviter qu'ils ne se dégradent par exemple en entrant en contact avec d'autres matériaux composant la tuyauterie et les vannes. Ainsi les précurseurs ne sont pas dévalués et peuvent être réutilisés pour le dépôt.

Le dispositif selon l'invention est particulièrement adapté au dépôt de catalyseurs nanostructurés sur des supports pour le traitement des gaz d'échappement automobiles.

La présente invention a alors pour objet un dispositif de dépôt chimique en phase vapeur d'un ou plusieurs métaux et/ou leurs alliages sur au moins une pièce comportant une surface intérieure, comme décrit dans la revendication 1.

Les moyens pour introduire le mélange gazeux avant dépôt peuvent comporter des moyens de connexion à la pièce de sorte à guider le mélange gazeux avant dépôt dans la pièce, ledit dispositif pouvant également comporter des moyens de connexion pour guider le mélange gazeux après dépôt en dehors de la pièce vers le circuit de récupération et de pompage.

Les moyens de connexion pour guider le mélange gazeux avant dépôt comportent par exemple un connecteur d'injection guidant le mélange gazeux avant dépôt dans la pièce et les moyens de connexion pour guider le mélange gazeux après dépôt comportent par exemple un connecteur d'évacuation évacuant le mélange gazeux après dépôt vers le circuit de pompage et de récupération, au moins le connecteur d'injection étant destiné à être en appui sur une zone extérieure d'une extrémité ouverte de la pièce.

Les moyens de recirculation sont de préférence isolés thermiquement afin d'éviter la baisse de la température du mélange gazeux après dépôt en dessous de sa température d'évaporation.

Les moyens de recirculation peuvent avantageusement comporter des moyens de chauffage de sorte à maintenir le mélange gazeux après dépôt au dessus de sa température d'évaporation.

Les moyens de recirculation peuvent comporter des moyens pour envoyer une partie du mélange gazeux après dépôt dans les moyens de recirculation et une autre partie dans le circuit de pompage et de récupération ; il s'agit par exemple d'une vanne de recirculation entre la zone de dépôt et le circuit de pompage et de récupération réglant la quantité du mélange gazeux après dépôt destinée à être réinjectée dans la zone de dépôt.

Le dispositif de dépôt chimique en phase vapeur comporte avantageusement des moyens pour récupérer le ou les métaux et/ou leurs alliages, lesdits moyens étant disposés au plus près de la zone de dépôt dans le circuit de pompage et de récupération. Les moyens pour récupérer le ou les métaux et/ou leurs alliages peuvent être connectés directement à une extrémité du connecteur d'évacuation opposée à une extrémité destinée à être connectée à la pièce.

Les moyens pour récupérer le ou les métaux et/ou leurs alliages peuvent être formés par un piège à haute température.

Le dispositif de dépôt chimique en phase vapeur peut également comporter un piège à azote liquide.

Dans un exemple de réalisation, la zone de dépôt est configurée pour recevoir au moins deux pièces empilées de sorte que le mélange avant dépôt soit injecté dans une des pièces et soit évacué par l'autre pièce et/ou peut comporter un barillet de chargement apte à contenir plusieurs pièces et à en disposer au moins une dans la zone de dépôt.

La présente invention a également pour objet un procédé de dépôt chimique en phase gazeuse d'un ou plusieurs métaux et/ou leur alliages sur au moins une pièce à partir d'un précurseur dudit métal à déposer ou des précurseurs desdits métaux à déposer et/ou de leurs alliages comme défini dans la revendication 10.

Le procédé de dépôt chimique en phase gazeuse peut comporter l'étape de récupération du métal ou des métaux et/ou leurs alliages contenus dans le mélange gazeux après dépôt dés leur récupération en sortie de la pièce. L'étape de récupération du métal ou des métaux et/ou leurs alliages se fait par exemple par contact avec une surface chaude.

De préférence, l'injection du précurseur ou des précurseurs est séparée dans le temps de l'injection du gaz réactif après une étape de mise au vide de l'intérieur de la pièce.

De préférence, la partie collectée du mélange gazeux après dépôt est maintenue à une température supérieure à sa température d'évaporation jusqu'à son injection à l'intérieur de la pièce.

Le procédé peut avantageusement comporter une étape préalable de réalisation au moins sur la surface intérieure de la pièce d'au moins une couche tampon dite "wash-coat" comportant un ou plusieurs oxydes mixtes de natures différentes, tels que Al₂O₃, CeO₂-ZrO₂, BaO₂, zéolithe, TiO₂ / V₂O₅... de sorte à augmenter la surface spécifique de la pièce, ladite couche tampon étant réalisée par exemple par imprégnation.

Le métal ou les métaux déposées sont par exemple choisis parmi le platine, le palladium et le rhodium.

Les pièces à traiter ont par exemple une structure en nid d'abeille et elles peuvent être en céramique, telle que la mullite, la cordiérite ou le carbure de silicium, ou en métal, tel que le FeCrAl...

### BRÈVE DESCRIPTION DES DESSINS

La présente invention sera mieux comprise sur la base de la description qui va suivre et des dessins en annexe sur lesquels:
- la figure 1 est une représentation schématique d'un dispositif de dépôt chimique en phase vapeur selon un exemple de réalisation selon l'invention;
- la figure 2 est une vue de détail au niveau d'un connecteur et d'une extrémité de la pièce du dispositif de la figure 1.

### EXPOSÉ DÉTAILLÉ DE MODES DE RÉALISATION PARTICULIERS

Dans la description qui va suivre, le dispositif de dépôt chimique en phase vapeur est utilisé pour réaliser un dépôt de catalyseurs métalliques sur des pièces destinées au traitement des gaz d'échappement émis par les véhicules automobiles. Par exemple, les pièces sont de forme cylindrique et ont une structure en nid d'abeille, de sorte à présenter des canaux sensiblement parallèles à l'axe du cylindre. Les gaz d'échappement s'écoulent à travers la pièce dans les canaux et réagissent avec les catalyseurs présents sur la surface des canaux.

Le dispositif selon l'invention s'applique à toutes les pièces comportant une structure intérieure dont la surface peut être recouverte d'un dépôt.

Le ou les matériaux dans lesquels les pièces sont réalisés peuvent présenter une porosité rendant possible une diffusion vers l'extérieur de la pièce mais celle-ci est considérée comme négligeable.

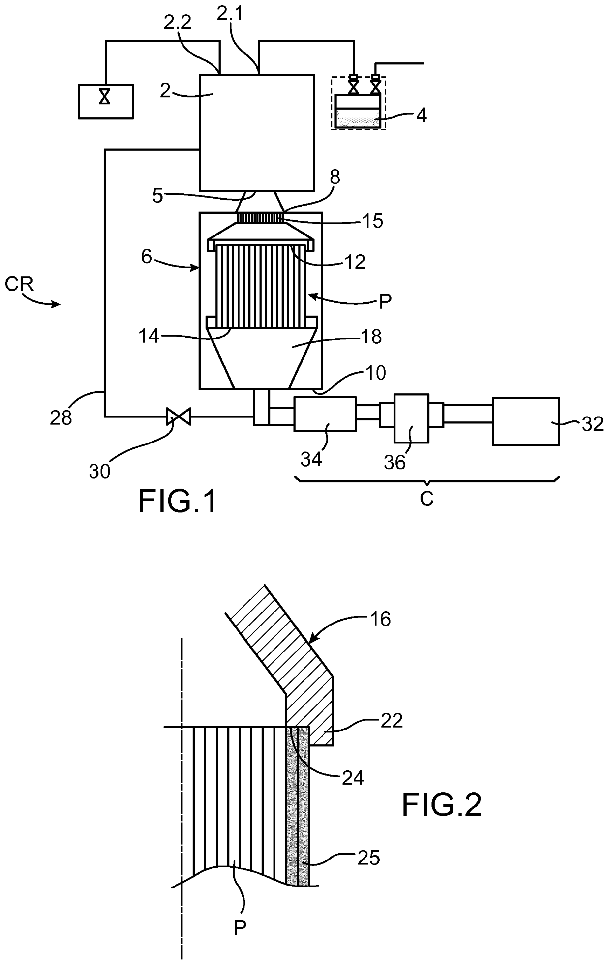

Sur la figure 1, est représenté schématiquement un exemple de dispositif de dépôt chimique en phase vapeur selon l'invention.

Le dispositif comporte un injecteur/évaporateur 2, une zone de dépôt 6 et un circuit de pompage et de récupération C.

L'injecteur/évaporateur 2, désigné par la suite "injecteur 2", comporte une première entrée d'admission 2.1 destinée à être connectée à un réservoir 4 de précurseurs liquides et une deuxième entrée d'admission 2.2 destinée à être connectée à un réservoir de gaz oxydant 3, par exemple de l'oxygène ou un mélange O₂/Ar. L'injecteur/évaporateur 2 comporte également une sortie d'injection 5.

La zone de dépôt 6 comporte une entrée d'injection 8 et une sortie d'évacuation 10. L'entrée d'injection 8 est connectée à la sortie d'injection 5 de l'injecteur/évaporateur 2.

Dans l'exemple représenté et de manière avantageuse, la zone de dépôt est formée directement par la pièce à l'intérieur de laquelle le dépôt doit avoir lieu. Dans l'exemple représenté, la pièce P a une forme de cylindre dont l'intérieur est une structure en nid d'abeille. La pièce P comporte deux extrémités longitudinales 12, 14.

Un connecteur d'injection 16 connecte la sortie d'injection à l'extrémité longitudinale 12 de la pièce P de sorte à guider le mélange gazeux sortant de l'injecteur/évaporateur 2 à l'intérieur de la pièce P. Dans l'exemple représenté, le connecteur d'injection 16 a une forme tronconique, la plus petite base étant connectée à la sortie d'injection de l'injecteur et la plus grande base étant connectée à l'extrémité longitudinale 14. Ce connecteur est également appelé "cône de forçage". De manière avantageuse, une élément 15 assurant une répartition des gaz dans le connecteur d'injection 16 est prévu entre l'injecteur 2 et le connecteur d'injection 16.

Un connecteur d'évacuation 18 est connecté d'une part à l'extrémité longitudinale 14 de la pièce P et d'autre part au circuit de pompage C.

Dans l'exemple représenté, le connecteur d'évacuation 18 a également la forme d'un tronc de cône la plus grande base étant du côté de la pièce P et la plus petite base étant du côté du circuit de pompage

La forme tronconique des connecteurs n'est en aucun cas limitative, ils pourraient être de forme tubulaire ou autre, ils permettent d'adapter le dispositif de dépôt à la forme des extrémités longitudinales de la pièce sans avoir à modifier la sortie d'injection de l'évaporateur et l'entrée du circuit de pompage.

La forme tronconique en amont de la zone de dépôt assure avantageusement la détente de la phase vapeur.

En aval de la zone de dépôt, la forme tronconique assure avantageusement la compression du gaz ce qui permet de limiter la vitesse du gaz dans la zone de dépôt.

Sur la figure 2, on peut voir une vue en coupe représentée schématiquement de la zone de connexion entre le connecteur d'injection et la pièce P selon un exemple de réalisation avantageux.

Le connecteur d'injection 16 comporte à son extrémité en contact avec la pièce une couronne périphérique 22 en saillie radialement vers l'extérieur destinée à loger l'extrémité longitudinale 12 de la pièce P et une portée annulaire 24 à l'intérieur de la couronne 22 destinée à venir en appui contre l'extrémité longitudinale 12 de la pièce. Ce contact est suffisant pour assurer l'étanchéité de connexion entre le connecteur d'injection 16 et la pièce P. Ce montage empêche un dépôt au niveau d'une zone périphérique 25 de la pièce P au droit de la zone de l'extrémité longitudinale de la pièce en contact avec la porté annulaire 24, mais cette absence de dépôt n'est pas gênante pour la fonction de la pièce P. La zone périphérique 25 est grisée sur la figure 2.

Cette réalisation permet d'éviter la mise en œuvre de joints d'étanchéité dont le matériau pourrait polluer le mélange gazeux.

De préférence, le connecteur d'injection est en matériau isolant thermique afin que celui-ci n'atteigne pas la température de la zone de dépôt sinon le dépôt aurait lieu sur le cône d'injection. Par exemple le connecteur d'injection est en céramique isolante thermique.

La forme du connecteur d'évacuation, en particulier au niveau de la connexion entre le connecteur d'évacuation 18 et l'extrémité longitudinale 14 de la pièce P peut être similaire à celle du connecteur d'injection.

En injectant le mélange gazeux directement à l'intérieur de la pièce et non dans le volume intérieur d'une chambre dans laquelle serait disposée la pièce et dont le volume intérieur serait rempli de mélange gazeux, le rapport entre la quantité de matériau déposée et la quantité de matériau injectée est sensiblement augmentée puisque la probabilité que les précurseurs réagissent et se déposent est augmentée. Le rendement de dépôt est donc augmenté. Selon l'invention seule la surface intérieure de la pièce est en contact avec le mélange gazeux. Il sera compris que des fuites au niveau des connexions et/ou une diffusion latérale à travers la paroi extérieure de la pièce peuvent apparaître mais la quantité de mélange mis en jeu dans ces fuites est très faible. Il peut encore être considéré que seule la surface intérieure entre en contact avec le mélange gazeux dans la zone de dépôt.

Il peut néanmoins être prévu de disposer la pièce dans une chambre de réaction, mais le mélange gazeux est toujours injecté directement dans la pièce.

Dans un mode avantageux, un circuit de recirculation CR du mélange gazeux est prévu et relie une zone de la zone de dépôt, située en aval de l'extrémité longitudinale 14 et de la pièce et une zone de la zone de dépôt, située en amont de l'extrémité longitudinale 12 de la pièce dans le sens de circulation du mélange gazeux.

Par exemple, le circuit de recirculation CR comporte un conduit 28, reliant la sortie du connecteur d'évacuation 18 et l'injecteur 2, et une vanne de recirculation 30 pour prélever une partie seulement du mélange gazeux sortant de la pièce, par exemple de 30 % à 50 %. De manière avantageuse, le circuit de recirculation CR est isolé thermiquement pour réduire les pertes thermiques afin d'éviter une condensation de tout ou partie du mélange gazeux et une décomposition prématurée des précurseurs. De manière encore plus avantageuse, des moyens de chauffage additionnels sont prévus pour maintenir le mélange gazeux recyclé au dessus de la température d'évaporation.

Il est prévu d'enrichir le mélange recyclé à partir de l'injecteur avant qu'il ne soit injecté dans la pièce.

Le circuit de pompage C comporte une pompe 32 destinée à la circulation du mélange gazeux dans le dispositif. La pompe 32 est par exemple une pompe primaire à palette.

Le circuit de pompage comporte avantageusement des moyens 34 destinés à piéger les précurseurs sortant de la zone de dépôt et qui ne sont donc pas déposés sur la pièce. Ces moyens 34 sont désignés piège à haute température. De manière préférée, le piège haute température est situé au plus près du connecteur d'évacuation en aval de celui-ci pour pouvoir récupérer les précurseurs au plus tôt après leur sortie de la pièce afin de réduire les risques de pollution de ceux-ci, pollution qui pourrait survenir lorsque les précurseurs entrent en contact des éléments du circuit de pompage.

Le piège à haute température permet de récupérer le métal des précurseurs organométalliques, par exemple il peut s'agir de Pt métallique, lorsque le précurseur est du Pt(acac), de Rhodium, lorsque le précurseur est du Rh(acac) ou du Palladium, lorsque le précurseur est du Pd(acac).

Le piège à haute température comporte par exemple une ou plusieurs plaques en à haute température, par exemple entre 100°C et 250°C. Ce type de piège comporte par exemple une ou plusieurs tôles réalisées en FeCrAl, les tôles sont avantageusement ondulées et enroulées formant une structure proche du nid d'abeille, ce qui provoque des turbulences et une perte de charge proche de celle de la pièce sur laquelle le dépôt a lieu.

De préférence, le piège à haute température est situé en amont de tous les éléments du circuit de pompage tels que la pompe et des vannes... De préférence, la pompe est alors située à l'extrémité aval du circuit, évitant que les précurseurs ne la traversent avant d'être piégés par les pièges à haute température.

En disposant le piège à haute température au plus près de la sortie de la pièce, les métaux récupérés présentent une forme chimique leur permettant d'être réutilisés directement pour former des précurseurs organométalliques liquides. Ils peuvent donc servir pour réalimenter le réservoir de précurseurs liquides, ils n'ont pas besoin de traitement coûteux pour pouvoir être revalorisés, contrairement aux dispositifs de l'état de la technique.

Le circuit de pompage peut également comporter un piège à azote liquide 36 disposé entre le piège à haute température et la pompe pour capter les solvants et les restes de précurseurs. Ceux-ci sont bien connus de l'homme du métier et ne seront pad décrits en détail. Ils sont par exemple fabriqués par Adixen de Alcatel Vacuum Technology.

Dans l'exemple décrit, la pièce traitée comporte deux extrémités ouvertes permettant l'injection du mélange gazeux par une extrémité ouverte et l'évacuation du mélange gazeux par l'autre extrémité ouverte. Le dispositif permet de traiter toutes formes de pièce. D'une part les pièces pourraient avoir toute forme par exemple courbée, d'autre part on pourrait envisager une pièce ne comportant qu'une extrémité ouverte permettant d'accéder à sa surface intérieure, dans ce cas l'injection et l'évacuation seraient effectuées par la même extrémité ouverte.

Dans l'exemple représenté sur la figure 1, une seule pièce est disposée dans la zone de dépôt. Mais on peut prévoir d'empiler les pièces à traiter de sorte que leurs axes longitudinaux soient alignés. Ainsi le connecteur d'injection est relié à une pièce à une extrémité de l'empilement et le connecteur d'évacuation est relié à une autre pièce à l'autre extrémité de l'empilement. Les pièces sont alors traitées successivement.

De manière avantageuse, les pièces peuvent être empilées sans nécessiter de moyens de connexion et d'étanchéité entre les pièces. En effet du fait de l'absence de flux sur une couronne extérieure dans les pièces, il n'y pas ou peu de fuite à la connexion des pièces. L'absence de moyens d'étanchéité entre les pièces permet de réduire encore les risques de pollution des précurseurs d'autant plus qu'ils sont destinés à être déposés sur la pièce suivante.

En variante, on pourrait prévoir une bague reliant les pièces adjacentes assurant le maintien mécanique, l'alignement et l'étanchéité.

Selon un autre exemple, les pièces peuvent être disposées dans un barillet situé dans la zone de dépôt de sorte à disposer une pièce à la fois entre les deux connecteurs. Lorsqu'une phase de dépôt, le barillet pivote, disposant une pièce non traitée entre les deux connecteurs. On peut envisager d'empiler les pièces dans le barillet et qu'à chaque position du barillet au moins deux pièces empilées soient exposées au mélange gazeux.

En variante encore, on peut envisager d'injecter le mélange gazeux dans plusieurs pièces simultanément, le connecteur d'injection présentant une extrémité connecté à l'injecteur et plusieurs d'extrémités d'injection, chaque extrémité d'injection étant connectée à une pièce. Le connecteur d'évacuation peut présenter une force correspondante.

Le dispositif permet de déposer par exemple des catalyseurs métalliques formés par des métaux précieux tels que le platine, le rhodium et le palladium. Le dispositif de dépôt est d'autant plus intéressant dans ce cas où le rendement de dépôt permet de réaliser des gains en coût de fabrication substantiels.

Les pièces à recouvrir peuvent avoir des géométries complexes telles que les pièces utilisées dans le domaine du traitement des effluents gazeux : mousses ou nids d'abeille en céramique, telle que la mullite, la cordiérite ou le carbure de silicium, ou en métal, tel que le FeCrAl...

Dans la réalisation de pièces dont une partie de la surface est recouverte d'un ou de plusieurs catalyseurs pour le traitement des gaz d'échappement, les précurseurs majoritairement utilisés sont des beta-dicetones. Ainsi, le Pt(acac) est dissous par exemple dans le toluène par exemple à une concentration de 0,03M, le Pd(acac) est dissous par exemple dans le toluène par exemple à une concentration de 0,025M et Rh(acac) est dissous par exemple dans le toluène par exemple à une concentration de à 0,03M.

Avantageusement le dépôt par le dispositif de dépôt chimique en phase vapeur peut compléter un dépôt réalisé préalablement par un procédé d'imprégnation dans lequel les précurseurs sont forcés à s'écouler à travers la pièce sous forme liquide. Le procédé d'imprégnation peut permettre de réaliser par exemple une couche tampon dite "wash-coat" homogène de grande surface spécifique accroissant la surface de réaction de la pièce. Ce wash-coat peut être composé d'un ou de plusieurs oxydes mixtes de nature différente, tels que Al₂O₃, CeO₂-ZrO₂, BaO₂, zéolithe, TiO₂ / V₂O₅, etc.).

En variante, ce wash-coat peut être réalisé par un procédé de dépôt de couche atomique ALD (Atomic Layer Deposition en terminologie anglaise) dans une enceinte de dépôt chimique en phase vapeur.

Nous allons maintenant décrire un procédé de réalisation d'un dépôt chimique en phase vapeur grâce au dispositif selon l'invention.

Lors d'une première étape, la ou les pièces sont disposées sur un porte-substrat et mises en place dans la zone de dépôt. Dans une étape préalable, les pièces peuvent être nettoyées par exemple dans un bain ultra-son par exemple avec de l'éthanol, de l'acétone ou du xylène. Avantageusement, avant le nettoyage, on peut prévoir de recouvrir les pièces d'un wash-coat afin d'augmenter leur surface spécifique, ce dépôt peut être réalisé par imprégnation.

Un vide est réalisé dans la pièce par exemple un vide primaire de l'ordre de 10⁻² Torr.

Lors d'une étape suivante, les pièces sont chauffées, par exemple par rayonnement, entre 250°C et 350°C.

Lors d'une étape suivante, le mélange gazeux contenant les précurseurs sont injectés dans la ou les pièces. La durée de l'injection dépend de l'épaisseur de la couche que l'on souhaite réaliser. Pendant le dépôt, les précurseurs sont avantageusement récupérés par le piège à haute température. De manière également avantageuse, une partie du mélange gazeux sortant de la zone de dépôt est réinjectée en entrée de la zone de dépôt après avoir été enrichie en précurseurs.

A la fin du dépôt, le chauffage est interrompu, la température des pièces diminue pour atteindre la température ambiante. Les pièce sont évacuées de la zone de dépôt et sont prêtes à être utilisées.

Lorsque du métal a été récupéré par le piège à haute température, il est réutilisé pour fabriquer des précurseurs métalliques qui peuvent être réinjectés pour le dépôt.

Il a été constaté que la structure du dépôt réalisée à partir des matériaux récupérés par le piège à haute température était avantageusement identique à celle obtenue à partir de matériaux frais.

Grâce au dispositif de dépôt selon l'invention mettant en œuvre le cône de forçage, la recirculation et le piège à haute température on peut atteindre un rendement de dépôt de l'ordre d'au moins 80% alors qu'il n'est que de l'ordre de 30% avec les dispositifs de l'état de la technique.

Le dispositif selon l'invention permet de réduire la quantité de mélange de gaz requis pour une étape de dépôt. En outre, il permet avantageusement de recycler une partie du mélange de gaz. De manière avantageuse, il permet également de récupérer au moins une partie du métal qui sort de la zone de dépôt, ce métal récupéré étant sous une forme facilement réutilisable.

Dans l'exemple de dispositif décrit ci-dessus, les précurseurs et l'oxygène sont injectés simultanément dans la zone de dépôt.

Selon un autre mode de réalisation, on peut prévoir d'injecter successivement les précurseurs et l'oxygène.

Par exemple, une première étape peut consister en l'introduction par le système d'injection d'une solution d'organométalliques finement divisée afin de saturer la surface de la pièce par la phase vapeur. L'injection peut durer entre 5 s à 20 s durant laquelle la pression peut augmenter de 1 mBar à 100 mBar. Lors d'une étape suivante, on purge le système jusqu'à 1 mBar par exemple puis on injecte l'oxygène à 10 mBar par exemple. S'ensuit la purge finale du premier cycle. Le nombre de cycles nécessaires dépend du taux de chargement visé, par exemple entre 20 cycles et 100 cycles typiquement pour un dépôt de 100 ppm à 1500 ppm de nanoparticules.

Grâce au dispositif de dépôt en phase vapeur, le dépôt en phase vapeur permet une imprégnation efficace d'une matrice macroporeuse telle que les mousses ou nids d'abeilles avec des porosités de 2 cpsi à 600 cpsi [canaux par pouce carré] et/ou 2 ppi à 60 ppi[ pores par pouce carré], par exemple pour réaliser des supports filtrants pour la catalyse.

Le dépôt conduit à un dépôt de couche active homogène non seulement du point de vue de l'épaisseur mais également de la structure.

Le dépôt en phase vapeur est donc particulièrement adapté à la réalisation de supports filtrants puisque l'imprégnation des parois filtrantes en profondeur d'un support catalytique favorise l'échange en volume et permet d'optimiser la surface spécifique et donc permet d'améliorer l'efficacité du support filtrant.

Les pièces ainsi réalisées peuvent par exemple être utilisée pour la dépollution des gaz d'échappement des véhicules automobiles. Elles peuvent également trouver leur application dans le domaine de traitement de l'air, par exemple pour les traitements des COV, NOx, pour la génération d'hydrogène par reformage, ou pour des matériaux de stockage de l'hydrogène, dans les piles à combustible.

Par exemple, le dispositif et le procédé selon l'invention sont adaptés à la réalisation des couches de diffusion de gaz ou "Gas diffusion layer" en terminologie anglo-saxonne équipant certaines piles à combustible. Ces couches comportent un tissu poreux tendu sur un cadre. Grâce au procédé selon l'invention, on peut réaliser un dépôt efficace de catalyseur, par exemple du platine, dans l'épaisseur du tissu. Les pores du tissu sont assimilables à des canaux comportant une surface intérieure. Le dispositif de dépôt selon l'invention comporte des connecteurs d'injection et d'évacuation en appui en amont et en aval sur le cadre, cet appui assurant l'étanchéité suffisante.

## Revendications

1. Dispositif de dépôt chimique en phase vapeur d'un ou plusieurs métaux et/ou leurs alliages sur au moins une pièce (P) comportant une surface intérieure, le dispositif comportant au moins une zone de dépôt (6), un évaporateur/injecteur (2) connecté à la zone de dépôt (6) afin de l'alimenter en un mélange gazeux dit "mélange gazeux avant dépôt" contenant un précurseur dudit métal à déposer ou des précurseurs desdits métaux à déposer et/ou de leurs alliages, et un circuit de pompage et de récupération (C) connecté à la zone de dépôt (6) de sorte à récupérer au moins en partie le mélange gazeux après dépôt, dit "mélange gazeux après dépôt", ladite zone de dépôt (6) étant destinée à recevoir la au moins une pièce (P) sur laquelle le dépôt chimique est effectué, ladite zone de dépôt (6) comportant des moyens de chauffage de ladite pièce et des moyens pour introduire le mélange gazeux avant dépôt directement à l'intérieur de la pièce (P) de sorte que seule la surface intérieure de la pièce (P) soit en contact avec le mélange gazeux avant dépôt, le dispositif comportant également des moyens de recirculation (CR) aptes à réinjecter une partie du mélange gazeux après dépôt dans la zone de dépôt et des moyens pour enrichir ledit mélange gazeux après dépôt avec le précurseur dudit métal à déposer ou des précurseurs desdits métaux à déposer et/ou de leurs alliages, avant la recirculation dans la zone de dépôt, et des moyens pour envoyer une partie du mélange gazeux après dépôt dans les moyens de recirculation et l'autre partie dans le circuit de pompage et de récupération.

2. Dispositif de dépôt chimique en phase vapeur selon la revendication 1, dans lequel les moyens pour introduire le mélange gazeux avant dépôt comportent des moyens de connexion à la pièce de sorte à guider le mélange gazeux avant dépôt dans la pièce, ledit dispositif comportant également des moyens de connexion pour guider le mélange gazeux après dépôt en dehors de la pièce vers le circuit de récupération et de pompage (C).

3. Dispositif de dépôt chimique en phase vapeur selon la revendication 1 ou 2, dans lequel les moyens de connexion pour guider le mélange gazeux avant dépôt comportent un connecteur d'injection (16) guidant le mélange gazeux avant dépôt dans la pièce (P) et les moyens de connexion pour guider le mélange gazeux après dépôt comportent un connecteur d'évacuation (18) évacuant le mélange gazeux après dépôt vers le circuit de pompage et de récupération (C), au moins le connecteur d'injection (16) étant destiné à être en appui sur une zone extérieure d'une extrémité ouverte de la pièce (P).

4. Dispositif de dépôt chimique en phase vapeur selon l'une des revendications 1 à 3, dans lequel les moyens de recirculation (CR) sont isolés thermiquement afin d'éviter la baisse de la température du mélange gazeux après dépôt en dessous de sa température d'évaporation.

5. Dispositif de dépôt chimique en phase vapeur selon la revendication 4, dans lequel les moyens de recirculation (CR) comportent des moyens de chauffage de sorte à maintenir le mélange gazeux après dépôt au-dessus de sa température d'évaporation et dans lequel les moyens de recirculation (CR) comportent une vanne de recirculation (30) entre la zone de dépôt et le circuit de pompage et de récupération (C) pour régler la quantité du mélange gazeux après dépôt destinée à être réinjectée dans la zone de dépôt.

6. Dispositif de dépôt chimique en phase vapeur selon l'une des revendications 1 à 5, comportant des moyens (34) pour récupérer le ou les métaux et/ou leurs alliages, lesdits moyens étant disposés au plus près de la zone de dépôt (6) dans le circuit de pompage et de récupération (C), lesdits moyens (34) pour récupérer le ou les métaux et/ou leurs alliages étant avantageusement formés par un piège à haute température.

7. Dispositif de dépôt chimique en phase vapeur selon la revendication 6 en combinaison avec la revendication 3, dans lequel les moyens (34) pour récupérer le ou les métaux et/ou leurs alliages sont connectés directement à une extrémité du connecteur d'évacuation (18) opposée à une extrémité destinée à être connectée à la pièce (P).

8. Dispositif de dépôt chimique en phase vapeur selon l'une des revendications 1 à 7, comportant un piège à azote liquide (36).

9. Dispositif de dépôt chimique en phase vapeur selon l'une des revendications 1 à 8, dans lequel la zone de dépôt (6) est configurée pour recevoir au moins deux pièces empilées de sorte que le mélange avant dépôt soit injecté dans une des pièces et soit évacué par l'autre pièce, ledit dispositif comportant avantageusement un barillet de chargement apte à contenir plusieurs pièces et à en disposer au moins une dans la zone de dépôt.

10. Procédé de dépôt chimique en phase gazeuse d'un ou plusieurs métaux et/ou leur alliages, lesdits métaux étant avantageusement choisis parmi le platine, le palladium et le rhodium, sur au moins une pièce à partir d'un précurseur dudit métal à déposer ou des précurseurs desdits métaux à déposer et/ou de leurs alliages comportant les étapes :
- chauffage de ladite pièce à une température permettant le dépôt chimique en phase vapeur,
- injection directement à l'intérieur de la pièce d'un précurseur dudit métal à déposer ou des précurseurs desdits métaux à déposer et/ou de leurs alliages et d'un gaz réactif, de sorte que seul le volume intérieur de la pièce soit en contact avec le précurseur dudit métal à déposer ou des précurseurs desdits métaux à déposer et/ou de leurs alliages et d'un gaz réactif,
- récupération d'un mélange gazeux, dit "mélange gazeux après dépôt",
- de collecte d'une partie du mélange gazeux après dépôt et d'envoi de l'autre partie du mélange gazeux après dans un circuit de pompage et de récupération,
- d'enrichissement de ladite partie collectée du mélange gazeux après dépôt avec le précurseur dudit métal à déposer ou les précurseurs desdits métaux à déposer et/ou de leurs alliages,
- d'injection à l'intérieur de la pièce de la partie collectée du mélange gazeux après dépôt enrichie,

11. Procédé de dépôt chimique en phase gazeuse selon la revendication 10, comportant l'étape de récupération du métal ou des métaux et/ou leurs alliages contenus dans le mélange gazeux après dépôt dès leur récupération en sortie de la pièce, l'étape de récupération du métal ou des métaux et/ou leurs alliages se faisant avantageusement par contact avec une surface chaude.

12. Procédé de dépôt chimique en phase vapeur selon la revendication 10 ou 11, dans lequel l'injection du précurseur ou des précurseurs est séparée dans le temps de l'injection du gaz réactif après une étape de mise au vide de l'intérieur de la pièce.

13. Procédé de dépôt chimique en phase gazeuse selon l'une des revendications 10 à 12, dans lequel ladite partie collectée du mélange gazeux après dépôt est maintenue à une température supérieure à sa température d'évaporation jusqu'à son injection à l'intérieur de la pièce.

14. Procédé de dépôt chimique en phase vapeur selon l'une des revendications 10 à 13, comportant une étape préalable de réalisation au moins sur la surface intérieure de la pièce d'au moins une couche tampon dite wash-coat comportant un ou plusieurs oxydes mixtes de natures différentes, tels que Al₂O₃, CeO₂-ZrO₂, BaO₂, zéolithe, TiO₂ / V₂O₅... de sorte à augmenter la surface spécifique de la pièce, ladite couche tampon étant réalisée par exemple par imprégnation.

15. Procédé de dépôt chimique en phase vapeur selon l'une des revendications 10 à 14, dans lequel les pièces à traiter ont une structure en nid d'abeille et/ou dans lequel les pièces à traiter sont en céramique, telle que la mullite, la cordiérite ou le carbure de silicium, ou en métal, tel que le FeCrAI...

## Patentansprüche

1. Vorrichtung zur chemischen Dampfphasenabscheidung eines oder mehrerer Metalle und/oder ihrer Legierungen auf zumindest einem Bauteil (P) mit einer Innenfläche, wobei die Vorrichtung zumindest eine Abscheidungszone (6) und einen Verdampfer/Injektor (2) enthält, der mit der Abscheidungszone (6) verbunden ist, um sie mit einem Gasgemisch, "Vorabscheidungs-Gasgemisch" genannt, zu versorgen, das einen Vorläufer des abzuscheidenden Metalls bzw. Vorläufer der abzuscheidenden Metalle und/oder ihrer Legierungen enthält, sowie einen Pump- und Rückgewinnungskreislauf (C), der mit der Abscheidungszone (6) verbunden ist, um zumindest einen Teil des Gasgemischs nach der Abscheidung, "Nachabscheidungs-Gasgemisch" genannt, zurückzugewinnen, wobei die Abscheidungszone (6) dazu bestimmt ist, das zumindest eine Bauteil (P) aufzunehmen, auf dem die chemische Abscheidung erfolgt, wobei die Abscheidungszone (6) Mittel zum Erhitzen des Bauteils und Mittel zum Einführen des Vorabscheidungs-Gasgemischs direkt in das Innere des Bauteils (P) enthält, so dass nur die Innenfläche des Bauteils (P) mit dem Vorabscheidungs-Gasgemisch in Kontakt ist, wobei die Vorrichtung ferner Rezirkulationsmittel (CR) enthält, die dazu geeignet sind, einen Teil des Nachabscheidungs-Gasgemischs in die Abscheidungszone wieder einzuführen, sowie Mittel zur Anreicherung des Nachabscheidungs-Gasgemischs mit dem Vorläufer des abzuscheidenden Metalls bzw. mit den Vorläufern der abzuscheidenden Metalle und/oder ihrer Legierungen vor der Rezirkulation in der Abscheidungszone, und Mittel zum Fördern des einen Teils des Nachabscheidungs-Gasgemischs in die Rezirkulationsmittel und des anderen Teils in den Pump- und Rückgewinnungskreislauf.

2. Vorrichtung zur chemischen Dampfphasenabscheidung nach Anspruch 1, wobei die Mittel zum Einführen des Vorabscheidungs-Gasgemischs Mittel zum Verbinden mit dem Bauteil enthalten, um das Vorabscheidungs-Gasgemisch in das Bauteil zu leiten, wobei diese Vorrichtung ferner Verbindungsmittel zum Leiten des Nachabscheidungs-Gasgemisches aus dem Bauteil heraus in den Rückgewinnungs- und Pumpkreislauf (C) enthält.

3. Vorrichtung zur chemischen Dampfphasenabscheidung nach Anspruch 1 oder 2,
wobei die Verbindungsmittel zum Leiten des Vorabscheidungs-Gasgemisches einen Zuführanschluss (16) enthalten, der das Vorabscheidungs-Gasgemisch in das Bauteil (P) leitet, und wobei die Verbindungsmittel zum Leiten des Nachabscheidungs-Gasgemisches einen Abführanschluss (18) enthalten, der das Nachabscheidungs-Gasgemisch in den Pump- und Rückgewinnungskreislauf (C) abführt, wobei zumindest der Zuführanschluss (16) dazu bestimmt ist, sich an einem äußeren Bereich eines offenen Endes des Bauteils (P) abzustützen.

4. Vorrichtung zur chemischen Dampfphasenabscheidung nach einem der Ansprüche 1 bis 3,
wobei die Rezirkulationsmittel (CR) thermisch isoliert sind, um zu verhindern, dass die Temperatur des Nachabscheidungs-Gasgemisches unter seine Verdampfungstemperatur fällt.

5. Vorrichtung zur chemischen Dampfphasenabscheidung nach Anspruch 4, wobei die Rezirkulationsmittel (CR) Heizmittel enthalten, um das Nachabscheidungs-Gasgemisch über seiner Verdampfungstemperatur zu halten, und wobei die Rezirkulationsmittel (CR) zwischen der Abscheidungszone und dem Pump- und Rückgewinnungskreislauf (C) ein Rezirkulationsventil (30) zum Einstellen der zum Wiederzuführen in die Abscheidungszone bestimmten Menge des Nachabscheidungs-Gasgemisches enthalten.

6. Vorrichtung zur chemischen Dampfphasenabscheidung nach einem der Ansprüche 1 bis 5,
enthaltend Mittel (34) zur Rückgewinnung des bzw. der Metalle und/oder ihrer Legierungen, wobei diese Mittel so nahe wie möglich an der Abscheidungszone (6) im Pump- und Rückgewinnungskreislauf (C) angeordnet sind, wobei diese Mittel (34) zur Rückgewinnung des bzw. der Metalle und/oder ihrer Legierungen vorteilhaft durch eine Hochtemperaturfalle gebildet werden.

7. Vorrichtung zur chemischen Dampfphasenabscheidung nach Anspruch 6 in Kombination mit Anspruch 3,
wobei die Mittel (34) zur Rückgewinnung des bzw. der Metalle und/oder ihrer Legierungen direkt mit einem Ende des Abführanschlusses (18) verbunden sind, welches einem Ende entgegengesetzt ist, das mit dem Bauteil (P) verbunden werden soll.

8. Vorrichtung zur chemischen Dampfphasenabscheidung nach einem der Ansprüche 1 bis 7,
enthaltend eine Flüssigstickstofffalle (36).

9. Vorrichtung zur chemischen Dampfphasenabscheidung nach einem der Ansprüche 1 bis 8,
wobei die Abscheidungszone (6) dazu ausgelegt ist, zumindest zwei gestapelte Bauteile aufzunehmen, so dass das Vorabscheidungs-Gemisch in eines der Bauteile eingeführt und durch das andere Bauteil abgeführt wird, wobei die Vorrichtung vorteilhaft eine Ladetrommel enthält, die dazu geeignet ist, mehrere Bauteile zu enthalten und zumindest eines davon in der Abscheidungszone anzuordnen.

10. Verfahren zur chemischen Dampfphasenabscheidung eines bzw. mehrere Metalle und/oder ihrer Legierungen, wobei die Metalle vorteilhaft ausgewählt sind aus Platin, Palladium und Rhodium, auf zumindest einem Bauteil ausgehend von einem Vorläufer des abzuscheidenden Metalls bzw. von Vorläufern der abzuscheidenden Metalle und/oder ihrer Legierungen, umfassend die Schritte:
- Erhitzen des Bauteils auf eine Temperatur, bei der die chemische Dampfphasenabscheidung möglich ist,
- Einführen eines Vorläufers des abzuscheidenden Metalls bzw. von Vorläufern der abzuscheidenden Metalle und/oder ihrer Legierungen und eines Reaktivgases direkt in das Innere des Bauteils, so dass nur der Innenraum des Bauteils mit dem Vorläufer des abzuscheidenden Metalls bzw. den Vorläufern der abzuscheidenden Metalle und/oder ihrer Legierungen und einem Reaktivgas in Kontakt steht,
- Rückgewinnen eines Gasgemisches, "Nachabscheidungs-Gasgemisch" genannt,
- Sammeln eines Teils des Nachabscheidungs-Gasgemisches und Zuführen des anderen Teils des Nachabscheidungs-Gasgemisches in einen Pump- und Rückgewinnungskreislauf,
- Anreichen des gesammelten Teils des Nachabscheidungs-Gasgemisches mit dem Vorläufer des abzuscheidenden Metalls bzw. den Vorläufern der abzuscheidenden Metalle und/oder ihrer Legierungen,
- Zuführen des gesammelten, angereicherten Teils des Nachabscheidungs-Gasgemischs in das Innere des Bauteils.

11. Verfahren zur chemischen Dampfphasenabscheidung nach Anspruch 10, umfassend den Schritt der Rückgewinnung des Metalls bzw. der Metalle und/oder ihrer Legierungen, die in dem Nachabscheidungs-Gasgemisch enthalten sind, bei deren Rückgewinnung aus dem Bauteil, wobei der Schritt der Rückgewinnung des Metalls bzw. der Metalle und/oder ihrer Legierungen vorteilhafterweise durch Kontakt mit einer heißen Oberfläche erfolgt.

12. Verfahren zur chemischen Dampfphasenabscheidung nach Anspruch 10 oder 11,
wobei die Zuführung des Vorläufers bzw. der Vorläufer zeitlich getrennt von der Zuführung des Reaktivgases nach einem Schritt der Anlegen ein Vakuum im Innenraum des Bauteils erfolgt.

13. Verfahren zur chemischen Dampfphasenabscheidung nach einem der Ansprüche 10 bis 12,
wobei der gesammelte Teil des Nachabscheidungs-Gasgemisches auf einer Temperatur oberhalb seiner Verdampfungstemperatur gehalten wird, bis er in das Innere des Bauteils eingeführt wird.

14. Verfahren zur chemischen Dampfphasenabscheidung nach einem der Ansprüche 10 bis 13,
umfassend einen vorherigen Schritt der Herstellung mindestens einer sogenannten Wash-Coat-Pufferschicht zumindest auf der Innenfläche des Bauteils, welche Schicht ein oder mehrere Mischoxide unterschiedlicher Natur, wie Al₂O₃, CeO₂-ZrO₂, BaO₂, Zeolith, TiO₂ / V₂O₅ usw. enthält, um die spezifische Oberfläche des Bauteils zu vergrößern, wobei die Pufferschicht beispielsweise durch Imprägnierung hergestellt wird.

15. Verfahren zur chemischen Dampfphasenabscheidung nach einem der Ansprüche 10 bis 14,
wobei die zu behandelnden Bauteile eine Wabenstruktur haben und/oder wobei die zu behandelnden Bauteile aus Keramik, wie Mullit, Cordierit oder Siliciumcarbid oder aus Metall, wie etwa FeCrAl, usw., bestehen.

## Claims

1. A device for the chemical vapour deposition of one or more metals and/or their alloys on at least one part (P) comprising an inner surface, the device comprising at least one deposition area (6), an evaporator/injector (2) connected to the deposition area (6) in order to supply it with a gaseous mixture called "gaseous mixture before deposition" containing a precursor of said metal to be deposited or precursors of said metals to be deposited and/or their alloys, and a pumping and recovery circuit (C) connected to the deposition area (6) so as to at least partly recover the gaseous mixture after deposition, called "gaseous mixture after deposition", said deposition area (6) being intended to receive the at least one part (P) on which the chemical deposition is carried out, said deposition area (6) comprising means for heating said part and means for introducing the gaseous mixture before deposition directly into the part (P) so that only the inner surface of the part (P) is in contact with the gaseous mixture before deposition, the device also comprising recirculation means (CR) capable of reinjecting a portion of the gaseous mixture after deposition into the deposition area and means for enriching said gaseous mixture after deposition with the precursor of said metal to be deposited or precursors of said metals to be deposited and/or their alloys, before recirculation in the deposition area, and means for sending a portion of the gaseous mixture after deposition in the recirculation means and the other portion in the pumping and recovery circuit.

2. The chemical vapour deposition device according to claim 1, wherein the means for introducing the gaseous mixture before deposition comprise means for connection to the part so as to guide the gaseous mixture before deposition into the part, said device also comprising connection means for guiding the gaseous mixture after deposition outside the part to the recovery and pumping circuit (C).

3. The chemical vapour deposition device according to claim 1 or 2, wherein the connection means for guiding the gaseous mixture before deposition comprise an injection connector (16) guiding the gaseous mixture before deposition in the part (P) and the connection means for guiding the gaseous mixture after deposition comprise an evacuation connector (18) evacuating the gaseous mixture after deposition towards the pumping and recovery circuit (C), at least the injection connector (16) being intended to be bearing on an outside area of an open end of the part (P).

4. The chemical vapour deposition device according to one of claims 1 to 3, wherein the recirculation means (CR) are thermally insulated in order to avoid the drop in the temperature of the gaseous mixture after deposition below its evaporation temperature.

5. The chemical vapour deposition device according to claim 4, wherein the recirculation means (CR) comprise heating means so as to keep the gaseous mixture after deposition above its evaporation temperature and wherein the recirculation means (CR) comprise a recirculation valve (30) between the deposition area and the pumping and recovery circuit (C) to regulate the amount of the gaseous mixture after deposition intended to be reinjected into the deposition area.

6. The chemical vapour deposition device according to one of claims 1 to 5, comprising means (34) for recovering the metal(s) and/or their alloys, said means being disposed as close as possible to the deposition area (6) in the pumping and recovery circuit (C), said means (34) for recovering the metal(s) and/or their alloys being advantageously formed by a high temperature trap.

7. The chemical vapour deposition device according to claim 6 in combination with claim 3, wherein the means (34) for recovering the metal(s) and/or their alloys are directly connected to one end of the evacuation connector (18) opposite an end intended to be connected to the part (P).

8. The chemical vapour deposition device according to one of claims 1 to 7, comprising a liquid nitrogen trap (36).

9. The chemical vapour deposition device according to one of claims 1 to 8, wherein the deposition area (6) is configured to receive at least two parts stacked so that the mixture before deposition is injected into one of the parts and is evacuated by the other part, said device advantageously comprising a loading barrel capable of containing several parts and of disposing at least one of them in the deposition area.

10. A method for the chemical gas phase deposition of one or more metals and/or their alloys, said metals being advantageously selected from platinum, palladium and rhodium, on at least one part from a precursor of said metal to be deposited or precursors of said metals to be deposited and/or their alloys comprising the steps:
- heating said part to a temperature allowing chemical vapour deposition,
- directly injecting into the part a precursor of said metal to be deposited or the precursors of said metals to be deposited and/or their alloys and a reactive gas, so that only the inner volume of the part is in contact with the precursor of said metal to be deposited or the precursors of said metals to be deposited and/or their alloys and a reactive gas,
- recovering a gaseous mixture, called "gaseous mixture after deposition",
- collecting a portion of the gaseous mixture after depositing and sending the other portion of the gaseous mixture afterwards in a pumping and recovery circuit,
- enriching said collected portion of the gaseous mixture after depositing, with the precursor, said metal to be deposited or the precursors of said metals to be deposited and/or their alloys,
- injecting into the part the enriched collected portion of the gaseous mixture after deposition.

11. The chemical gas phase deposition method according to claim 10, comprising the step of recovering the metal(s) and/or their alloys contained in the gaseous mixture after deposition as soon as they are recovered at the outlet of the part, the step of recovering the metal(s) and/or their alloys being advantageously carried out by contact with a hot surface.

12. The chemical vapour deposition method according to claim 10 or 11, wherein the injection of the precursor(s) is separated in time of the injection of the reactive gas after a step of applying vacuum to the interior of the part.

13. The chemical gas phase deposition method according to one of claims 10 to 12, wherein said collected portion of the gaseous mixture after deposition is maintained at a temperature above its evaporation temperature until it is injected into the part.

14. The chemical vapour deposition method according to one of claims 10 to 13, comprising a prior step of producing at least on the inner surface of the part at least one buffer layer called wash-coat comprising one or more mixed oxides of different natures, such as Al₂O₃, CeO₂-ZrO₂, BaO₂, zeolite, TiO₂/V₂O₅ ... so as to increase the specific surface of the part, said buffer layer being produced for example by impregnation.

15. The chemical vapour deposition method according to one of claims 10 to 14, wherein the parts to be treated have a honeycomb structure and/or wherein the parts to be treated are made of ceramic, such as mullite, cordierite or silicon carbide, or metal, such as FeCrAI.
